# EUROPEAN PATENT APPLICATION

(11) **EP 0 769 528 A2**
(43) Date of publication of application: **23.04.1997**
(21) Application number: 96307543.7
(22) Date of filing: 17.10.1996
(51) Int. Cl.: C08L 83/04

(54) **Organopolysiloxane composition for impregnating electronic components and electronic components impregnated therewith**

(30) Priority: 18.10.1995 JP 294895/95; 14.02.1996 JP 51054/96
(71) Applicant: Dow Corning Toray Silicone Company Ltd., Ichihara-shi, Chiba Prefecture (JP)
(72) Inventor: Ishiki, Minoru, Dow Corning Toray Silicone Co. Ltd, Ichihara-shi, Chiba, Prefecture (JP); Mine, Katsutoshi, Dow Corning Toray Silicone Co., Ichihara-shi, Chiba, Prefecture (JP); Takeuchi, Takae, Dow Corning Toray Silicone Co., Ichihara-shi, Chiba, Prefecture (JP); Yamakawa, Kimio, Dow Corning Toray Silicone Co., Ichihara-shi, Chiba, Prefecture (JP)
(74) Representative: Lewin, John Harvey

(57) **Abstract**

An organopolysiloxane composition is disclosed for impregnating electronic components, that is a fluid with a viscosity at 25°C of 5 to 1,000 mPa.s (centipoise) comprising
(A) diorganopolysiloxane that contains alkenyl at both molecular chain terminals, but at no other position on the molecular chain,
(B) diorganopolysiloxane that contains silicon-bonded hydrogen atoms at both molecular chain terminals, but at no other position on the molecular chain, in a quantity that provides 0.1 to 3 moles of silicon-bonded hydrogen atom from component (B) per 1 mole of alkenyl group in component (A),
(C) organopolysiloxane that contains at least 3 silicon-bonded hydrogen atoms in each molecule, in a quantity that provides 0.01 to 0.3 mole of silicon-bonded hydrogen atom from component (C) per 1 mole of alkenyl group in component (A), and
(D) platinum catalyst in a quantity that provides 0.1 to 500 weight-ppm of platinum metal from component (D) in the instant composition. Also disclosed is an electronic component that has been impregnated with the above composition.

## Description

This invention relates to an organopolysiloxane composition for impregnating electronic components that displays an excellent processability and endows said components with an excellent moisture resistance. The invention also relates to highly moisture-resistant electronic components.

Electronic components, for example, transistors, diodes, capacitors, coils, large scale integration devices (LSIs), and integrated circuits may be coated with a sealant resin, such as epoxy, polyphenylene sulfide, or silicone. Nevertheless, impurities such as water, sodium ion, and chloride ion, may enter through void spaces that are present in the electronic component as well as through void spaces between the sealant resin and component leads. This can cause a drastic decline in the reliability of the electronic component. A method to improve component reliability consists of impregnating the void spaces of the electronic component with an organopolysiloxane composition (JP-A 60-63938).

A curable organopolysiloxane composition that crosslinks by addition reaction to form a cured gel or rubber is also generally used (JP-A 3-252115) to combat the problem of post-impregnation bleed-out when the void spaces in the component are impregnated with noncuring organopolysiloxane. One example of a composition used for this purpose is taught in JP-A 4-370151. This composition comprises organopolysiloxane containing at least 2 silicon-bonded vinyl groups in each molecule, organopolysiloxane containing at least 2 silicon-bonded hydrogen atoms in each molecule, and platinum catalyst.

However, the stresses generated by exposure to thermal shock readily cause a decline in component reliability electronic components which use a composition that cures by addition reaction into a rubber or gel. To respond to this problem, JP-A 6-100782 has proposed an organopolysiloxane composition comprising diorganopolysiloxane having vinyl at only both molecular chain terminals, diorganopolysiloxane having silicon-bonded hydrogen at only both molecular chain terminals, and a platinum catalyst. This composition takes the form of a low-viscosity fluid during impregnation of the electronic component, but after impregnation it crosslinks through an addition reaction to give a high-viscosity fluid. As a result, this composition resists bleed-out and can thoroughly relax the stresses generated whenever the component is subjected to thermal shock.

The above composition, however, has a high addition-reaction rate that results in poor processability in sealing electronic components. A satisfactory impregnation cannot be obtained unless the process is run at low temperatures or is run rapidly. The addition reaction of this composition is inhibited through the admixture of known addition-reaction inhibitors, but large amounts of these inhibitors must be added to achieve a satisfactory inhibition.

We have unexpectedly achieved the present invention as a result of extensive investigations directed to solving the problems described above.

In specific terms, the object of this invention is to introduce an organopolysiloxane composition for impregnating electronic components that displays an excellent processability and that endows electronic components with an excellent moisture resistance. An additional object is to provide highly moisture-resistant electronic components.

The organopolysiloxane composition of the present invention for impregnating electronic components is a fluid with a viscosity at 25°C of 5 to 1,000 mPa.s (centipoise) comprising
(A) diorganopolysiloxane that contains alkenyl at both molecular chain terminals, but at no other position on the molecular chain,
(B) diorganopolysiloxane that contains silicon-bonded hydrogen atoms at both molecular chain terminals, but at no other position on the molecular chain, in a quantity that provides from 0.1 to 3 moles of silicon-bonded hydrogen from component (B) per 1 mole of alkenyl in component (A),
(C) organopolysiloxane that contains at least 3 silicon-bonded hydrogen atoms in each molecule, in a quantity that provides from 0.01 to 0.3 mole of silicon-bonded hydrogen from component (C) per 1 mole of alkenyl in component (A), and
(D) platinum catalyst in a quantity that provides from 0.1 to 500 weight-ppm of platinum metal from component (D) in the instant composition.

Electronic components according to the present invention are characterized in that our composition is capable of being impregnated into the void spaces of electronic components and thereafter being crosslinked by addition reaction.

Our organopolysiloxane composition for impregnating electronic components will be considered in detail.

The diorganopolysiloxane (A), bears alkenyl groups at only both molecular chain terminals. This alkenyl is exemplified by vinyl, allyl, butenyl, pentenyl, hexenyl, and heptenyl, with vinyl being specifically preferred. The non-alkenyl organic groups in component (A) are exemplified by alkyl groups such as methyl, ethyl, propyl, butyl, pentyl, hexyl, and heptyl; aryl groups such as phenyl, tolyl, xylyl, and naphthyl; aralkyl groups such as benzyl and phenethyl; and haloalkyl groups such as chloromethyl, 3-chloropropyl and 3,3,3-trifluoropropyl. Methyl and phenyl are specifically preferred. The molecular structure of component (A) is substantially straight-chain, although it may contain branching chains to some degree. Component (A) has a viscosity at 25°C preferably from 5 to 10,000 mPa.s (centipoise) and more preferably from 10 to 1,000 mPa.s (centipoise) because these ranges yield a good impregnability by the resulting composition and a low volatility. The subject diorganopolysiloxane (A) is exemplified by dimethylvinylsiloxy-endblocked dimethylpolysiloxanes, dimethylvinylsiloxy-endblocked dimethylsiloxane-methylphenylsiloxane copolymers, and dimethylvinylsiloxy-endblocked dimethylsiloxane-methyl(3,3,3-trifluoropropyl)siloxane copolymers. Dimethylvinylsiloxy-endblocked dimethylpolysiloxanes are particularly preferred.

The hydrogen terminated diorganopolysiloxane (B), which is a crosslinker for the composition under consideration, contains silicon-bonded hydrogen atoms at only both molecular chain terminals. The Si-bonded organic groups in component (B) are exemplified by the same organic groups as elaborated above, and again methyl and phenyl are specifically preferred. The molecular structure of component (B) is also substantially straight-chain, although it may contain branching chains to some degree. Component (B) has a viscosity at 25°C preferably from 1 to 1,000 mPa.s (centipoise) and more preferably from 5 to 500 mPa.s (centipoise) because these ranges also yield a good impregnability by the resulting composition and a low volatility. The subject diorganopolysiloxane (B) is exemplified by dimethylhydrogensiloxy-endblocked dimethylpolysiloxanes, dimethylhydrogensiloxy-endblocked dimethylsiloxane-methylphenylsiloxane copolymers, and dimethylhydrogensiloxy-endblocked dimethylsiloxane-methyl(3,3,3-trifluoropropyl)siloxane copolymers. Dimethylhydrogensiloxy-endblocked dimethylpolysiloxanes are particularly preferred.

Component (B) is added to the subject composition in a quantity that provides from 0.1 to 3 moles, and preferably from 0.5 to 1.5 moles of silicon-bonded hydrogen atom from component (B) per 1 mole of alkenyl group in component (A). A satisfactory viscosity increase does not occur when the composition contains less than 0.1 mole of silicon-bonded hydrogen from component (B) per 1 mole alkenyl in component (A). When the composition contains more than 3 moles of silicon-bonded hydrogen per mole of alkenyl, foaming is prone to occur and the impregnability into electronic components will be diminished.

The organopolysiloxane (C), which is a crosslinker for the composition under consideration, also functions to preserve the composition's capacity to impregnate electronic components through a suitable inhibition of the addition reaction between the alkenyl groups in component (A) and the silicon-bonded hydrogen atoms in component (B). Component (C) contains at least 3 silicon-bonded hydrogen atoms in each molecule. Although the usual approach to inhibiting the addition reaction between the alkenyl in component (A) and the SiH in component (B) is to add a conventional addition-reaction inhibitor, such as an acetylenic compound or an ene-yne compound, this approach does not provide sufficient inhibition of the addition-reaction rate when these functional groups are located at only the molecular chain terminals. In contrast, the use of component (C) in the present composition serves to inhibit the addition reaction in the composition; for example, the composition will exhibit a very small rise in viscosity. Thus, the use of component (C) thereby makes possible a lengthy impregnation operation. The silicon-bonded hydrogen in component (C) can be bonded, for example, in terminal and/or nonterminal positions on the molecular chain, with bonding in nonterminal position on the molecular chain being particularly preferred. The organic groups in component (C) are exemplified by the same organic groups as elaborated above, and methyl and phenyl are particularly preferred. Component (C) can have a straight-chain, branched, cyclic, network, or partially branched straight-chain molecular structure, with straight-chain structures being preferred. Component (C) has a viscosity at 25°C preferably from 1 to 1,000 mPa.s (centipoise), and more preferably from 5 to 500 mPa.s (centipoise) because these ranges yield a good impregnability by the resulting composition and a low volatility.

Organopolysiloxane (C) is exemplified by trimethylsiloxy-endblocked methylhydrogenpolysiloxanes; trimethylsiloxy-endblocked dimethylsiloxane-methylhydrogensiloxane copolymers; trimethylsiloxy-endblocked dimethylsiloxane-methylhydrogensiloxane-methylphenylsiloxane copolymers; dimethylhydrogensiloxy-endblocked dimethylsiloxane-methylhydrogensiloxane copolymers; dimethylhydrogensiloxy-endblocked dimethylsiloxane-methylhydrogensiloxane-methylphenylsiloxane copolymers; organopolysiloxanes composed of R¹₃SiO_{1/2} and R¹₂(H)SiO_{1/2} siloxane units and a small amount of SiO_{4/2} siloxane unit; organopolysiloxanes composed of the R¹₂(H)SiO_{1/2} siloxane unit and a small amount of the SiO_{4/2} siloxane unit; organopolysiloxanes composed of the R¹(H)SiO_{2/2} and R¹SiO_{3/2} siloxane units; and mixtures of two or more of the preceding organopolysiloxanes. R¹ represents monovalent hydrocarbon groups, excluding alkenyl groups, and is exemplified by alkyl groups such as methyl, ethyl, propyl, butyl, pentyl, hexyl, and heptyl; aryl groups such as phenyl, tolyl, xylyl, and naphthyl; aralkyl groups such as benzyl or phenethyl; and haloalkyl groups such as chloromethyl, 3-chloropropyl and 3,3,3-trifluoropropyl. Methyl and phenyl are specifically preferred here.

Component (C) is added in an amount that provides from 0.01 to 0.3 mole of silicon-bonded hydrogen and preferably from 0.02 to 0.15 mole of silicon-bonded hydrogen atom from component (C) per 1 mole of alkenyl group in component (A). When the composition contains less than 0.01 mole silicon-bonded hydrogen from component (C) per 1 mole alkenyl in component (A), it will exhibit poor processing characteristics in the impregnation of electronic components due to an inadequate inhibition of the addition reaction. When the composition contains more than 0.3 mole silicon-bonded hydrogen from component (C) per 1 mole alkenyl in component (A), its addition reaction-based crosslinking will undesireably yield a cured product having the form of a gel or rubber.

The platinum catalyst (D) is a catalyst that accelerates the addition reaction in the subject composition. Component (D) is exemplified by platinum black, platinum-on-silica, platinum-on-active carbon, chloroplatinic acid, alcohol solutions of chloroplatinic acid, platinum-olefin complexes, and platinum-divinyltetramethyldisiloxane complexes.

Component (D) is added in a quantity that will provide from 0.1 to 500 weight-ppm of platinum metal from component (D) in the subject composition. The addition reaction in the composition will be very slow when component (D) provides less than 0.1 weight-ppm of platinum metal. At the other end of the range, exceeding 500 ppm does not lead to a significant change in the addition-reaction rate and thus is uneconomical.

The known addition-reaction inhibitors can be added to our composition as an optional component for the purpose of increasing the storage stability and adjusting the addition-reaction rate. These addition-reaction inhibitors are exemplified by acetylenic compounds such as 3-methyl-1-butyn-3-ol, 3,5-dimethyl-1-hexyn-3-ol, and 3-phenyl-1-butyn-3-ol; ene-yne compounds such as 3-methyl-3-penten-1-yne or 3,5-dimethyl-3-hexen-1-yne; alkenyl-functional siloxanes such as 1,3,5,7-tetramethyl-1,3,5,7-tetravinylcyclotetrasiloxane or 1,3,5,7-tetramethyl-1,3,5,7-tetrahexenylcyclotetrasiloxane; triazoles such as benzotriazole; phosphines; mercaptans; and hydrazines. The addition-reaction inhibitor is preferably added to our composition at from 10 to 5,000 weight-ppm.

Other components can also be added to the subject composition on an optional basis insofar as the objects of the invention are not impaired. Examples of other optional components are inorganic fillers such as precipitated silica, fumed silica, calcined silica, fumed titanium oxide, crushed quartz, diatomaceous earth, asbestos, aluminosilicates, iron oxide, zinc oxide, calcium carbonate, and carbon black. The fillers afforded by treating the aforementioned fillers with hydrophobing agents may also be used. Representative treating agents include an organosilicon compound such as an organohalosilane, organoalkoxysilane, organosilazane, and organopolysiloxane; methyltrimethoxysilane; ethyltrimethoxysilane, vinyltrimethoxysilane; allyltrimethoxysilane, 3-methacryloxypropyltrimethoxysilane, 3-glycidoxypropyltrimethoxysilane, 3,4-epoxycyclohexylethyltrimethoxysilane, tetramethoxysilane, tetraethoxysilane, and methyl Cellosolve orthosilicate; organosiloxane oligomers such as oligomers containing in each molecule epoxy-functional organic and Si-bonded alkoxy groups, organosiloxane oligomers containing in each molecule epoxy-functional organic, Si-bonded alkoxy and alkenyl groups, organosiloxane oligomers containing in each molecule epoxy-functional organic and Si-bonded alkoxy groups, and hydrogen atom, and organosiloxane oligomers containing in each molecule Si-bonded alkoxy and alkenyl groups; pigments; dyes; flame retardants; and organic solvents.

The initial viscosity of the composition under consideration at 25°C in the range from 5 to 1,000 mPa.s (centipoise), and preferably is in the range from 10 to 300 mPa.s (centipoise). A composition with an initial viscosity at 25°C below 5 mPa.s (centipoise) is very volatile and will contaminate the surrounding equipment with its volatile components. At the other end of the range, a composition with a viscosity in excess of 1,000 mPa.s (centipoise) has a poor capacity to impregnate electronic components. A characteristic feature of the present composition is that it is a low-viscosity fluid before its addition reaction, which endows it with an excellent capacity to impregnate electronic components. Another characteristic feature of our composition is that its crosslinking by addition reaction forms a fluid with a higher viscosity than the pre-crosslinked fluid. As a result, after the addition reaction, our composition resists bleed-out or migration from the electronic component, and is also able to thoroughly relax the stresses generated when the component is subjected to thermal shock. The viscosity of the fluid yielded by the addition-crosslinking of our composition (i.e., the post crosslinking viscosity) is preferably at least 5 times, more preferably at least 10 times, and even more preferably at least 50 times, the viscosity of the fluid prior to the addition reaction.

Electronic components of the present invention will now be considered in greater detail.

An electronic component of the present invention will itself present void spaces in its structure or will present a void space at the sealant resin/lead interface. Examples of such electronic components are transistors, diodes, capacitors, coils, LSIs, and integrated circuits.

Figure 1 contains a cross section of the electronic component (LSI) used in the examples.

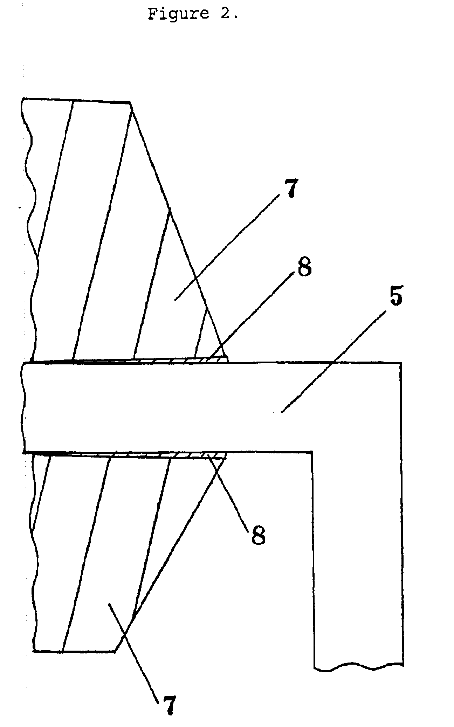

Figure 2 contains an enlarged view of a portion of the electronic component (LSI) of Figure 1.

### Reference Numbers

1 semiconductor element
2 tab
3 bonding pad
4 bonding pad
5 lead frame
6 gold bonding wire
7 transparent epoxy resin
8 addition reaction-crosslinking organopolysiloxane composition for impregnating electronic components

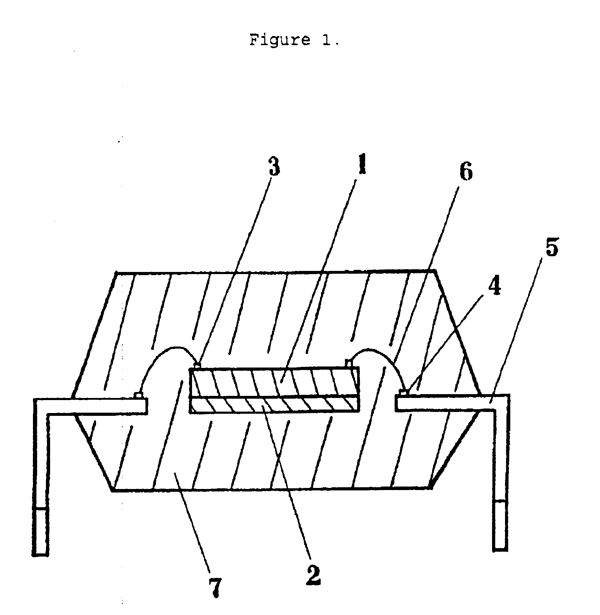

The discussion of electronic components of our invention will continue with reference to the LSI depicted in Figure 1. This LSI is fabricated by fixing a semiconductor element 1 on a tab 2, electrically connecting the bonding pads 3 elaborated on the top edge of the semiconductor element 1 through bonding wires 6 to the bonding pads 4 elaborated at the edges of the lead frame 5, and finally resin-sealing the semiconductor element 1 with a resin sealant such as an epoxy resin 7 or the like. It is often the case, however, that such an LSI will have void spaces or gaps of 0.01 to 5 micrometers at the interface between the epoxy resin 7 and lead frame 5. In electronic components of the claimed invention, this void space or gap has been fully impregnated with the composition described above and the composition has then been crosslinked by addition reaction.

Techniques for fabricating electronic components of the present invention are exemplified by dipping the electronic component in our composition at ambient temperature and pressure, dipping the electronic component in the same composition under elevated or reduced pressure, and dipping the electronic component in our composition at ambient temperature and pressure while applying ultrasonic vibration. In the case of relatively low-viscosity compositions, a thorough impregnation into the void spaces of the electronic component is achieved merely by dipping in the composition at ambient temperature and pressure. After impregnation into the component's void spaces, the excess composition remaining on the surface of the electronic component is removed as necessary, and the component is heated preferably to 50°C to 200°C, and more preferably to 100°C to 150°C.

As described above, our organopolysiloxane composition for impregnating electronic components exhibits an excellent processability in the impregnation of electronic components and is capable of providing a thorough impregnation into the void spaces and gaps in electronic components. These characteristics make possible the use of our composition as an impregnating agent for a variety of electronic components. Moreover, due to the excellent moisture resistance exhibited by electronic components fabricated as described herein, said components are highly qualified for service as components (e.g., transistors, diodes, capacitors, coils, LSIs, and integrated circuits) that are used under relatively severe conditions.

### EXAMPLES

The organopolysiloxane composition of the present invention for impregnating electronic components, and impregnating electronic components derived thereby will be described in greater detail in the following working examples. The viscosity values reported were measured at 25°C, while H/Vi in the examples refers to the molar ratio of Si-bonded hydrogen in component (B) (or component (C)) to vinyl in component (A). The following methods were used to fabricate the electronic components and evaluate their moisture resistance.

### Fabrication of electronic components

Fabrication of the electronic components will be explained with reference to Figure 1. The electronic components were fabricated by fixing a semiconductor element 1 (aluminum circuit interconnects were formed on the surface of this element) on a tab 2, electrically connecting the bonding pads 3 elaborated on the top edge of the semiconductor element 1 through gold bonding wires 6 to the bonding pads 4 elaborated at the edges of the lead frame 5, and finally resin-sealing the semiconductor element 1 with a transparent epoxy resin 7. The gap in the fabricated components between the transparent epoxy resin 7 and lead frame 5 was measured using a microscope, and those components with a gap of 0.01 to 5 micrometers were selected. The selected components were immersed for 1 second at ambient temperature and pressure in the particular organopolysiloxane composition impregnating agent. Fabrication of the electronic component was then completed by heating for 1 hour at 150°C.

### Moisture resistance of electronic components

After fabrication, the electronic components were heated for 1,000 or 3,000 hours in the presence of water vapor (85°C and 85% RH). Current was then applied to the component's lead frame and the leakage current across the lead frame was measured. The moisture resistance was evaluated as the percentage of defective electronic components (components in which a change had occurred in the leakage current).

### Example 1

The following were mixed to homogeneity to yield an organopolysiloxane composition for impregnating electronic components: 80 weight parts of dimethylvinylsiloxy-endblocked dimethylpolysiloxane (viscosity = 100 mPa.s [centipoise], vinyl content = 0.95 weight%) as component (A); 15.9 weight parts of dimethylhydrogensiloxy-endblocked dimethylpolysiloxane (viscosity = 15 mPa.s [centipoise], silicon-bonded hydrogen content = 0.13 weight%, H/Vi = 0.73) as component (B); 0.1 weight part of trimethylsiloxy-endblocked methylhydrogenpolysiloxane (viscosity = 20 mPa.s [centipoise], silicon-bonded hydrogen content = 1.6 weight%, H/Vi = 0.06) as component (C); platinum/1,3-divinyl-1,1,3,3-tetramethyldisiloxane complex as component (D) in a quantity providing 5 weight-ppm of platinum metal from this complex in the composition; and 3-phenyl-1-butyn-3-ol as an optional (inhibitor) component at 200 weight-ppm in the composition.

Table 1 reports the results from the evaluation of the properties of this composition and the moisture resistance of electronic components fabricated from this composition.

### Example 2

The following were mixed to homogeneity to yield an organopolysiloxane composition for impregnating electronic components: 80 weight parts of dimethylvinylsiloxy-endblocked dimethylpolysiloxane (viscosity = 100 mPa.s [centipoise], vinyl content = 0.95 weight%) as component (A); 15.7 weight parts of dimethylhydrogensiloxy-endblocked dimethylpolysiloxane (viscosity = 15 mPa.s [centipoise], silicon-bonded hydrogen content = 0.13 weighty, H/Vi = 0.72) as component (B); 0.3 weight part of trimethylsiloxy-endblocked methylhydrogensiloxane-dimethylsiloxane copolymer (methylhydrogensiloxane : dimethylsiloxane molar ratio = 5 : 3, viscosity = 5 mPa.s [centipoise], silicon-bonded hydrogen content = 0.73 weight%, H/Vi = 0.08) as component (C); platinum/1,3-divinyl-1,1,3,3-tetramethyldisiloxane complex as component (D) in a quantity providing 5 weight-ppm of platinum metal from this complex in the composition, and 3-phenyl-1-butyn-3-ol as an optional (inhibitor) component at 200 weight-ppm in the composition.

Table 1 also reports the results from the evaluation of the properties of this composition and the moisture resistance of electronic components fabricated using this composition.

### Example 3

The following were mixed to homogeneity to yield an organopolysiloxane composition for impregnating electronic components: 80 weight parts of dimethylvinylsiloxy-endblocked dimethylpolysiloxane (viscosity = 100 mPa.s [centipoise], vinyl content = 0.95 weight%) as component (A); 15.9 weight parts of dimethylhydrogensiloxy-endblocked dimethylpolysiloxane (viscosity = 15 mPa.s [centipoise], silicon-bonded hydrogen content = 0.13 weight%, H/Vi = 0.73) as component (B); 0.1 weight part of trimethylsiloxy-endblocked methylhydrogenpolysiloxane (viscosity = 20 mPa.s [centipoise], silicon-bonded hydrogen content = 1.6 weight%, H/Vi = 0.06) as component (C); platinum/1,3-divinyl-1,1,3,3-tetramethyldisiloxane complex as component (D) in a quantity providing 5 weight-ppm of platinum metal from this complex in the composition; and 1,3,5,7-tetramethyl-1,3,5,7-tetravinylcyclotetrasiloxane as an optional (inhibitor) component at 1,000 weight-ppm in the composition.

Table 1 contains the results from the evaluation of the properties of this composition and the moisture resistance of electronic components fabricated using this composition.

### Comparative Example 1

An organopolysiloxane composition for impregnating electronic components was prepared as in Example 1, but in this case without the addition of component (D).

Table 1 lists the results from the evaluation of the properties of this composition and the moisture resistance of electronic components fabricated using this composition.

### Comparative Example 2

An organopolysiloxane composition for impregnating electronic components was prepared as in Example 1 with the following modifications: component (C) was entirely omitted, and the addition of component (B) was changed to 16 weight parts (H/Vi = 0.73).

Table 1 also lists the results from the evaluation of the properties of this composition and the moisture resistance of electronic components fabricated using this composition.

### Comparative Example 3

An organopolysiloxane composition for impregnating electronic components was prepared as in Example 1 with the following modifications: component (B) was entirely omitted, and the addition of component (C) in was changed to 16 weight parts (H/Vi = 9.0).

Table 1 gives the results from the evaluation of the properties of this composition and the moisture resistance of electronic components fabricated using this composition.

**Table 1**

| | present invention | | | comparative examples | | |
|---|---|---|---|---|---|---|
| | Ex. 1 | Ex. 2 | Ex. 3 | Comp. Ex. 1 | Comp. Ex. 2 | Comp. Ex. 3 |
| properties of the organopolysiloxane compositions for impregnating electronic components | | | | | | |
| immediately after preparation: viscosity (mPa.s/cP) | 92 | 94 | 90 | 92 | 92 | 98 |
| after 24 hours at 25°C: condition | fluid | fluid | fluid | fluid | fluid | rubber |
| viscosity (mPa.s/cP) | 98 | 115 | 128 | 92 | 8000 | NM |
| after 1 hour at 150°C: condition | fluid | fluid | fluid | fluid | fluid | rubber |
| viscosity (mPa.s/cP) | 12000 | 10000 | 14000 | 92 | 8500 | NM |
| moisture resistance of the electronic components | | | | | | |
| % defects after 1,000h | 0 | 0 | 0 | 10 | 0 | 5 |
| % defects after 3,000h | 0 | 0 | 0 | 25 | 5 | 10 |
| NM = not measurable | | | | | | |

## Claims

1. A polyorganosiloxane composition for impregnating electronic components, said polyorganosiloxane composition comprising:
(A) a diorganopolysiloxane containing an alkenyl group at each molecular chain terminal, but at no other position on the molecular chain;
(B) a hydrogen-terminated diorganopolysiloxane containing silicon-bonded hydrogen atoms at both molecular chain terminals, but at no other position on the molecular chain, in a quantity that provides 0.1 to 3 moles of silicon-bonded hydrogen atoms from component (B) per mole of alkenyl group in component (A);
(C) an organopolysiloxane that contains an average of at least 3 silicon-bonded hydrogen atoms per molecule, in a quantity that provides 0.01 to 0.3 mole of silicon-bonded hydrogen atomfrom component (C) per mole of alkenyl group in component (A); and
(D) platinum catalyst in a quantity that provides 0.1 to 500 weight-ppm of platinum metal from component (D) in the polyorganosiloxane composition,
wherein the initial viscosity, at 25°C, of said polyorganosiloxane composition is 5 to 1,000 mPa.s (centipoise) and the post-crosslinking viscosity, at 25°C, of said polyorganosiloxane composition is greater than its initial viscosity.

2. The polyorganosiloxane of claim 1 wherein the viscosity, at 25°C, of component (A) is 5 to 10,000 mPa.s (centipoise).

3. The polyorganosiloxane of claim 1 or 2 wherein the viscosity, at 25°C, of component (B) is 1 to 1,000 mPa.s (centipoise).

4. The polyorganosiloxane of any of claims 1 to 3 wherein the viscosity, at 25°C, of component (C) is 1 to 1,000 mPa.s (centipoise).

5. The polyorganosiloxane of any of claims 1 to 4 wherein the initial viscosity of said polyorganosiloxane is 10 to 300 mPa.s (centipoise).

6. The polyorganosiloxane of any of claims 1 to 5 wherein the post-crosslinking viscosity of said polyorganosiloxane is at least 5 times greater than the initial viscosity of said polyorganosiloxane.

7. A moisture resistant electronic component prepared by impregnating an electronic component with the composition of any of claims 1 to 6 and then crosslinking said composition by addition reaction.

8. Use of a polyorganosiloxane composition according to any of claims 1 to 6 for impregnating an electronic component.
